# EUROPÄISCHE PATENTANMELDUNG

(11) **EP 4 841 273 A1**
(43) Veröffentlichungstag der Anmeldung: **18.11.2026**
(21) Anmeldenummer: 26174937.8
(22) Anmeldetag: 27.04.2026
(51) Int. Cl.: G01R 19/165, G01R 31/40

(54) **VERFAHREN UND SYSTEM ZUR SENSORÜBERWACHUNG IN EINEM MODULAREN ELEKTRISCHEN SYSTEM**

(30) Priorität: 14.05.2025 DE 102025118697
(71) Anmelder: Volkswagen Aktiengesellschaft, 38440 Wolfsburg (DE)
(72) Erfinder: Götz, Stefan, 38440 Wolfsburg (DE); Tashakor, Nima, 38440 Wolfsburg (DE); Amirrezai, Masoud, 38440 Wolfsburg (DE); Bayati, Mahdi, 38440 Wolfsburg (DE)

(57) **Zusammenfassung**

Die Erfindung betrifft ein Verfahren und ein System zur Sensorüberwachung in einem modularen elektrischen System (1), welches mehrere Module (M1, M2, ..., MN) mit jeweils einem Quellensubmodul (2) und einem Schaltsubmodul (3) zur Aktivierung oder Deaktivierung des Moduls (M1, M2, ..., MN) umfasst, umfassend die Schritte:
a) Einstellen mindestens eines Systemkonfigurationszustands,
b) Erfassen einer zustandsspezifischen Systemspannung (V_o) mit einem systemspezifischen Spannungssensor (4) für den mindestens einen Systemkonfigurationszustand,
c) Bestimmen von mindestens einem Sensorparameter des systemspezifischen Spannungssensors (4) und/oder Detektion einer Fehlfunktion des systemspezifischen Spannungssensors (4) in Abhängigkeit der zustandsspezifischen Systemspannung (V_o).

## Beschreibung

Die Erfindung betrifft ein Verfahren und ein System zur Sensorüberwachung in einem modularen elektrischen System.

Modulare Elektronik hat ein immenses Potenzial, doch ihre Komplexität erschwert auch die Überwachungs- und Schutzfunktionen. Es gibt umfangreiche Forschungsarbeiten zur Entwicklung und Gestaltung von Überwachungsschaltungen und -funktionen für elektronische Schaltungen, auch in der Automobilbranche. Die Messungen/Sensoren sind jedoch nach wie vor der Schwachpunkt in diesen Systemen, da sie langwierige Inbetriebnahmeverfahren und kostspielige regelmäßige Wartung erfordern.

Aufgrund von Fertigungstoleranzen weisen die Sensoren als Schlüsselkomponente eines Überwachungssystems inhärente Unterschiede auf. Darüber hinaus sind die Komponenten des Überwachungssystems auch anfällig für Verzerrungen, Parameterdrift, Alterung und Ausfall, was die Gesamtleistung des Systems erheblich beeinträchtigen kann.

Die Skalierbarkeit und das enorme Potenzial von modularen elektrischen Systeme gehen auf Kosten der Komplexität und der strengeren Anforderungen für einen stabilen und sicheren Betrieb. Da sich modulare, rekonfigurierbare Strukturen wie Speicher-/Batteriesysteme (und Photovoltaiksysteme) immer mehr durchsetzen, ist der Bedarf an genauen und zuverlässigen Sensormessungen von entscheidender Bedeutung, um deren optimale Leistung und Sicherheit zu gewährleisten.

Es gibt jedoch mehrere Herausforderungen, die mit der Bewältigung sensorbezogener Probleme in diesen Systemen verbunden sind:
- Unsicheres Verhalten der Sensoren: Sensorungenauigkeiten können aufgrund von Fertigungsschwankungen, Alterung, Umweltfaktoren oder Beschädigungen auftreten, was zu unsicherem Verhalten führt und die Leistung und Sicherheit des Systems beeinträchtigen kann.
- Abwägung zwischen Austauschbarkeit der Module und Wartung: Die Möglichkeit des Austauschs, Entfernens oder Hinzufügens von Modulen zu diesen Systemen zur Anpassung an neue Anforderungen macht die Wartung dieser Systeme problematisch, da jedes hinzugefügte oder ausgetauschte Modul einen neuen Inbetriebnahme- und Neukalibrierungsprozess erfordert.
- Kompromiss zwischen Sensorkosten und Genauigkeit: Hochpräzise Sensoren sind in der Regel mit höheren Kosten verbunden, während preiswertere Sensoren oft weniger genaue Messungen liefern. Es ist jedoch eine Herausforderung, ein Gleichgewicht zu finden, das die Kosten minimiert und gleichzeitig eine angemessene Systemleistung und Sicherheit gewährleistet.
- Allmähliche Divergenz: Im Laufe der Zeit kann die Ungenauigkeit der Sensoren zu einer allmählichen Abweichung der gemessenen Werte von den tatsächlichen Werten führen, was die Gesamtleistung des Systems beeinträchtigt und möglicherweise unentdeckte Probleme verursacht. Außerdem kann die Dynamik der Sensoren und ihrer Parameter im Laufe der Zeit oder bei Änderungen der Betriebsbedingungen von den Nennwerten abweichen.
- Querempfindlichkeit und Einfluss von Umgebungsbedingungen: Sensoren sind in der Regel nicht nur von der entsprechenden Messgröße sondern auch von diversen anderen Einflüssen abhängig. Beispielsweise ist nahezu jeder Sensor auch gleichzeitig temperaturabhängig. Die Korrektur von solchen Querempfindlichkeiten benötigt in der Regel eine intensive Charakterisierung der Sensoren für eine Vielzahl von Einflussfaktoren, um das Verhalten beispielsweise mathematisch zu beschreiben, und gegebenenfalls weitere und unter Umständen kostenintensive Sensoren in einem Produkt, um Korrekturen basierend auf den weiteren Sensorsignalen vorzunehmen. Ferner sind manche Querempfindlichkeiten unbekannt und können entsprechend unkontrolliert das Ausgangssignal des Sensors in unerwünschter Weise verändern.
- Störungen und Ausfälle: Unentdeckte Sensorfehler können zu Systemausfällen oder Sicherheitsrisiken führen, die ungeplante Ausfallzeiten, erhöhte Wartungskosten und potenzielle Schäden an der Ausrüstung oder der Umwelt nach sich ziehen.

Die US9,325,282 B2 betrifft integrierte Schaltungen im Allgemeinen und insbesondere integrierte Schaltungen, die Schaltungstopologien verwenden, die eine höhere Fertigungsausbeute ermöglichen.

Die US11,320,810 B2 betrifft das Gebiet der autonomen oder halbautonomen Geräte, insbesondere der multimodalen Sensorik in autonom fahrenden Fahrzeugen mit Selbstheilungsfähigkeiten.

Weiter bekannte Lösungen zur Sensorüberwachung bestehen aus redundanten Messungen. Dies ist z. B. in der US2020/397546 A1 beschrieben. Dies ist jedoch sehr kostspielig und erfordert hohe Bandbreiten für die Signalübertragung. Nachteilig ist, dass mit der Methode keine Verzerrungen korrigierbar sind; diese empfindlich auf allmähliche Abweichungen bei den Sensor- oder Modellparametern reagiert und von der Genauigkeit des Modells abhängt.

Das Dokument "S. Dey, S. Mohon, P. Pisu and B. Ayalew, "Sensor Fault Detection, Isolation, and Estimation in Lithium-lon Batteries," in IEEE Transactions on Control Systems Technology, vol. 24, no. 6, pp. 2141-2149, Nov. 2016, doi: 10.1109/TCST.2016.2538200" beschreibt einen modellbasierten Ansatz, um Spannungen an Modulen zu schätzen.

Das Dokument "J. Lu, Y. Hu, G. Chen, Z. Wang and J. Liu, "Mutual Calibration of Multiple Current Sensors With Accuracy Uncertainties in IPMSM Drives for Electric Vehicles," in IEEE Transactions on Industrial Electronics, vol. 67, no. 1, pp. 69-79, Jan. 2020, doi: 10.1109/TIE.2019.2896320" beschreibt einen Ansatz der regelmäßige Wartung von modularen elektrischen Systemen. Durch häufige Kalibrierung und Wartung können allmähliche Sensorverzerrungen und -fehler erkannt und korrigiert werden. Diese Methode hat den Nachteil, dass unter Umständen ein Betrieb des Systems behindert wird, insbesondere wenn das System abgeschaltet werden muss, geschultes Personal für HV-Systeme erforderlich ist, hohe Kosten entstehen und es nach jeder Änderung wiederholt werden muss, z. B. beim Austausch eines Moduls.

Das Dokument "K. Zhang, X. Hu, Y. Liu, X. Lin and W. Liu, "Multi-fault Detection and Isolation for Lithium-Ion Battery Systems," in IEEE Transactions on Power Electronics, vol. 37, no. 1, pp. 971-989, Jan. 2022, doi: 10.1109/TPEL.2021.3098445" beschreibt verschachtelte Messungen zwischen Batteriezellen in einer Serienschaltung. Es ermöglicht jedoch keine Korrektur von Verzerrungen, reagiert empfindlich auf allmähliche Veränderungen der Parameter oder des Verhaltens und ist schwierig beim Austausch oder Hinzufügen von Modulen anzuwenden.

Das Dokument "X. Hu, K. Zhang, K. Liu, X. Lin, S. Dey and S. Onori, "Advanced Fault Diagnosis for Lithium-Ion Battery Systems: A Review of Fault Mechanisms, Fault Features, and Diagnosis Procedures," in IEEE Industrial Electronics Magazine, vol. 14, no. 3, pp. 65-91, Sept. 2020, doi: 10.1109/MIE.2020.2964814" beschreibt datengestützte Verfahren zur Fehlerdiagnose. Es erfordert jedoch umfangreiche Messdatensätze, die in der Regel schwer zu beschaffen sind, weist eine geringe Zuverlässigkeit und unklares Verhalten auf, ist empfindlich gegenüber allmählicher Parameterdrift in den Modulen und den Sensoren sowie gegenüber Verzerrungen und weist geringe Generalisierungseigenschaften auf, insbesondere muss es bei jeder Änderung neu trainiert werden.

Das Dokument N. Tashakor, J. Kacetl, D. Keshavarzi and S. Goetz, "Topology, Analysis, and Modulation Strategy of a Fully Controlled Modular Reconfigurable DC Battery Pack With Interconnected Output Ports for Electric Vehicles," in IEEE Transactions on Transportation Electrification, vol. 10, no. 1, pp. 1180-1193, March 2024, doi: 10.1109/TTE.2023.3263775 beschreibt modulare batterieintegrierte Wandler oder die so genannten dynamisch rekonfigurierbaren Batteriepakete.

Es stellt sich daher das technische Problem, in modular ausgestalteten elektrischen Systemen eine zuverlässige Bestimmung von Sensorparametern zu ermöglichen, insbesondere um Sensorverzerrungen zu kompensieren und/oder eine zuverlässige Fehlererkennung zu ermöglichen.

Die Lösung des technischen Problems ergibt sich durch die Gegenstände mit den Merkmalen der unabhängigen Ansprüche. Weitere vorteilhafte Ausgestaltungen der Erfindung ergeben sich aus den Unteransprüchen.

Vorgeschlagen wird ein Verfahren zur Sensorüberwachung, insbesondere zur Spannungssensorüberwachung, in einem modularen elektrischen System. Das Verfahren kann zur Sensorkalibrierung und/oder zur Fehlerdetektion dienen.

Ein modulares elektrisches System kann ein elektrisches System bezeichnen, das aus mehreren weitgehend einheitlichen Modulen besteht. Module in einem solchen System können in der Regel mit minimalen Auswirkungen auf den Gesamtentwurf hinzugefügt oder entfernt werden. Modulare rekonfigurierbare Systeme bestehen in der Regel aus Modulen mit aktiv steuerbaren Elementen (elektrische, einschließlich elektronischer, oder mechanische Schalter oder Relais), mit denen die Gesamtarchitektur (z. B. die Art und Weise, wie die Module das größere Teilsystem bilden) geändert und das System angepasst bzw. um (neue) Funktionen erweitert werden kann. Modulare elektrische System weisen eine hohe Flexibilität, Skalierbarkeit und Anpassungsfähigkeit auf. Das modulare elektrische System kann insbesondere ein leistungselektronisches System sein, insbesondere zur Energiespeicherung und zur (erneuerbare) Energieerzeugung. Rekonfigurierbare modulare elektrische Speichersysteme (z. B. Batterien) ermöglichen in vorteilhafter Weise eine dynamische Anpassung der Konfiguration von Speicherelementen an unterschiedliche Energieanforderungen und Betriebsbedingungen. Diese Systeme können aus einzelnen Modulen bestehen, die in Reihe oder parallel geschaltet werden können, so dass die Spannungs- und Stromstärke je nach Bedarf angepasst werden kann. Diese Anpassungsfähigkeit erhöht die Gesamtleistung, Effizienz und Lebensdauer des Energiespeichersystems und senkt gleichzeitig die Kosten, da der Austausch einzelner Module anstelle des gesamten Systems (z. B. des Batteriepacks) erleichtert wird.

Modulare rekonfigurierbare Photovoltaik (PV)-Systeme sowie Superkondensatoren sind eine weitere Anwendung von modularen elektrischen Systemen. Diese Systeme können aus einzelnen Solarmodulen, die in verschiedenen Konfigurationen angeschlossen werden können, bestehen, um die Energieausbeute unter verschiedenen Umgebungsbedingungen wie variabler Sonnenlichtintensität oder teilweiser Verschattung zu maximieren. Indem sie Anpassungen der Systemkonfiguration in Echtzeit ermöglichen, können modulare rekonfigurierbare PV-Systeme die Gesamteffizienz, Belastbarkeit und Zuverlässigkeit der Solarenergieerzeugung verbessern.

Ein weiteres Ausführungsbeispiel für ein modulares elektrisches System ist ein System zur Strom- oder Spannungswandlung, insbesondere Multilevel-Wandler.

Allgemein gesprochen bestehen modulare und auch rekonfigurierbare elektrische Systeme aus mehreren insbesondere austauschbaren Modulen, die leicht rekonfiguriert werden können, um sich an veränderte Betriebsbedingungen, Anforderungen oder Umgebungen anzupassen. In der grundlegendsten Struktur können die Module in geschaltet oder überbrückt werden.

Das modulare elektrische System umfasst mehrere Module mit jeweils einem Quellensubmodul. Das Quellensubmodul dient zur Bereitstellung elektrischer Energie und kann insbesondere mindestens oder genau eine Spannungsquelle oder Stromquelle umfassen. Eine Spannungsquelle kann als Batteriezelle oder Akkumulator ausgebildet sein. Es ist aber auch vorstellbar, dass die Spannungsquelle als Photovoltaikzelle oder in anderer Form ausgebildet ist. Ein Modul umfasst weiter ein Schaltsubmodul zur Aktivierung oder Deaktivierung des Moduls.

Mit anderen Worten kann ein Modul mindestens ein elektrisches Quellen- oder Energiespeicherelement umfassen, wobei die Möglichkeit besteht, zwei oder mehr dieser Elemente zu kaskadieren. Weiter kann es eine konfigurierbare Schalteinrichtung umfassen, die es dem Modul ermöglicht, seine elektrische Verbindung innerhalb des Systems dynamisch zu ändern, insbesondere um mit mindestens einem anderen Modul eine Reihenschaltung oder Parallelschaltung oder eine Quasi-DC-DC-Stufe (bei denen das Modul mit einem Bruchteil seiner Spannung oder Leistung zum Gesamtsystem beitragen kann) zu bilden. Auch ist durch die Schalteinrichtung eine Bypass-Konfiguration einstellbar, in denen das entsprechende Modul nicht aktiv Teil des Systems ist.

Die Schalteinrichtung kann aus elektronischen Komponenten (z. B. MOSFETs, IGBTs, FETs) oder mechanischen Elementen (z. B. Relais) bestehen, die in Topologien wie Einzelschaltern, Halbbrücken, Vollbrücken und/oder deren Kombinationen angeordnet sein können. Solche Komponenten/Elemente sind u.a. in dem Dokument N. Tashakor, J. Kacetl, D. Keshavarzi and S. Goetz, "Topology, Analysis, and Modulation Strategy of a Fully Controlled Modular Reconfigurable DC Battery Pack With Interconnected Output Ports for Electric Vehicles," in IEEE Transactions on Transportation Electrification, vol. 10, no. 1, pp. 1180-1193, March 2024, doi: 10.1109/TTE.2023.3263775 beschrieben. Diesbezüglich kann also auf den Offenbarungsgehalt des entsprechenden Dokuments verwiesen werden.

Induktive und/oder kapazitive Komponenten können zwischen den Modulen und zwischen den Quellen- und Schaltsubmodulen oder Bestandteilen dieser Submodule geschaltet sein, z.B. um ein Einschwingverhalten oder eine Filterung zu unterstützen.

Jedes Modul kann ausgewählte Messpunkte an den Quellsubmodulen oder Bestandteilen eines solchen Submoduls und/oder an den Schaltsubmodulen oder Bestandteilen eines solchen Submoduls, insbesondere einem Ausgangsanschluss, aufweisen. Es ist jedoch denkbar, dass einige Module keine Messpunkte aufweisen und modulspezifische Größen in Abhängigkeit von Messungen bei anderen Module oder auf Systemebene bestimmt werden können.

Durch Einstellung von einem aktivierten Schaltzustand kann das Modul, insbesondere also das Quellensubmodul, aktiviert werden. Im aktivierten Zustand ist es Teil des modularen elektrischen Systems. Durch Einstellung von einem deaktivierten Schaltzustand kann das Modul, insbesondere also das Quellensubmodul, deaktiviert werden. Im deaktivierten Zustand ist das Modul nicht Teil des elektrischen Systems. Mit anderen Worten kann mit dem Schaltsubmodul ein Zustand geändert werden, wie das Quellensubmodul in das elektrische System eingebunden ist.

Umfasst das modulare elektrische System z. B. eine Reihenschaltung, so kann das Modul im aktivierten Zustand in Serie mit anderen Modulen der Reihenschaltung geschaltet sein. Im deaktivierten Zustand kann es überbrückt sein. Umfasst das modulare elektrische System z. B. eine Parallelschaltung, so kann das Modul im aktivierten Zustand parallel zu anderen Modulen der Parallelschaltung geschaltet sein. Im deaktivierten Zustand kann es von der Parallelschaltung getrennt sein. Das modulare elektrische System kann hierbei mindestens eine Reihenschaltung und/oder mindestens eine Parallelschaltung von Modulen umfassen.

Jedes Modul umfasst also mindestens eine Art von Energiespeicher/Quelle oder Umwandlungseinheit (ES oder EC) und ein elektronisches (oder sogar mechanisches) Teil, das den Zustand ändern kann, durch den das ESS in die Gesamtstruktur eingebunden ist.

Bei den Schaltelementen der Schaltsubmoduls kann es sich um mechanische oder elektronische Komponenten handeln, idealerweise unter Verwendung von MOSFETS, IGBTs, Thyristoren, GAN und SiCs.

Das modulare elektrische System umfasst mindestens einen systemspezifischen Spannungssensor. Dieser dient insbesondere zur Erfassung einer Ausgangsspannung des Systems. Bevorzugt, aber für zumindest eine Ausführungsform nicht zwingend, umfasst das System für jedes Modul mindestens einen modulspezifischen Spannungssensor. Dieser dient insbesondere zur Erfassung einer Ausgangsspannung des entsprechenden Moduls.

Es ist auch möglich, dass das modulare elektrische System einen systemspezifischen Stromsensor umfasst, der insbesondere zur Erfassung eines Eingangs- oder Ausgangsstroms des Systems dient, und/oder für jedes Modul mindestens einen modulspezifischen Stromsensor umfasst, der insbesondere zur Erfassung einer Ausgangsspannung des entsprechenden Moduls dient.

Es ist auch möglich, dass das modulare elektrische System für jedes Modul mindestens einen Temperatursensor umfasst, der insbesondere zur Erfassung einer Temperatur des entsprechenden Moduls dient.

Ein Sensor kann hierbei mit einer Steuer- und Auswerteeinrichtung des Systems daten- und/oder signaltechnisch verbunden sein. Es ist vorstellbar, dass die Sensoren mit einer modulspezifischen Steuer- und Auswerteeinrichtung verbunden sind, wobei diese wiederum mit der erläuterten systemspezifischen Steuer- und Auswerteeinrichtung verbunden sind. Eine Steuer- und Auswerteeinrichtung kann als Recheneinrichtung ausgebildet sein oder eine solche umfassen, wobei eine Recheneinrichtung als Mikrocontroller oder integrierte Schaltung ausgebildet oder eine(n) solche(n) umfassen kann.

Das modulare elektrische System kann z. B. eine Modulanzahl N von (de)aktivierbaren Modulen umfassen. Mit diesen Modulen kann eine Spannungslevelanzahl M von verschiedenen Systemausgangsspannungslevel eingestellt werden. Bevorzugt ist das Modulausgangsspannungslevel jedes Moduls gleich oder weichen die Level nicht mehr als ein vorbestimmtes Maß, z. B. 10% oder 5% eines gemittelten Modulausgangsspannungslevels, voneinander ab. In diesem Fall kann die Levelanzahl M der Modulanzahl N entsprechen, insbesondere im Fall, dass alle Module in Reihe geschaltet werden können.

Bevorzugt ist kein Filterelement zur Spannungsfilterung zwischen den Modulen und den Systemausgangsanschlüssen angeordnet.

Das Verfahren umfasst die Schritte:
a) Einstellen mindestens eines Systemkonfigurationszustands,
b) Erfassen einer zustandsspezifischen Systemspannung mit einem systemspezifischen Spannungssensor für den mindestens einen Systemkonfigurationszustand,
c) Bestimmen von mindestens einem Sensorparameter des systemspezifischen Spannungssensors und/oder Detektion einer Sensorfehlfunktion in Abhängigkeit der zustandsspezifischen Systemspannung. Durch die Bestimmung des mindestens einen Sensorparameters und/oder die Detektion der Sensorfehlfunktion erfolgt eine Sensorüberwachung.

Das Einstellen mindestens eines Systemkonfigurationszustands umfasst das Einstellen eines aktivierten oder deaktivierten Zustands von Modulen. Somit kann ein elektrisches System mit vorbestimmten Eigenschaften bereitgestellt werden. Beispielhafte Systemzustände werden nachfolgend noch näher erläutert. In der einfachsten Form können alle Module deaktiviert werden und somit ein Leerlaufzustand des Systems hergestellt werden. Dann wird in diesem Arbeitspunkt als zustandsspezifische Systemspannung eine Leerlaufspannung des Systems erfasst.

Dann kann z. B. als Sensorparameter eine Verzerrung (Bias) des systemspezifischen Spannungssensors für den Spannungsnullpunkt als diese Leerlaufspannung bestimmt werden. Andere Sensorparameter, die mit dem vorgeschlagenen Verfahren bestimmt werden können, sind eine Alterung oder eine Veränderung der Verzerrung oder Alterung. Nach der Bestimmung des Sensorparameters kann ein Ausgangssignal des Sensors in Abhängigkeit des Sensorparameters bestimmt werden. Somit wird auch ein Verfahren zur Bestimmung eines Sensorausgangssignals beschrieben, welches die erläuterte Bestimmung von mindestens einem Sensorparameter sowie die Bestimmung des Sensorausgangssignals in Abhängigkeit des derart bestimmten Sensorparameters umfasst.

Alternativ oder kumulativ kann eine Sensorfehlfunktion des systemspezifischen Spannungssensors detektiert werden, wenn die Leerlaufspannung um mehr als ein vorbestimmtes Maß von einem vorbestimmten Spannungslevel, z. B. einer Nullspannung, abweicht. Vorzugsweise und wie nachfolgend noch näher erläutert werden jedoch eine Vielzahl unterschiedlicher Systemkonfigurationszustände eingestellt und das Bestimmen des Sensorparameters und/oder die Detektion der Sensorfehlfunktion in Abhängigkeit der zustandsspezifischen Systemspannung durchgeführt. Wird eine Fehlfunktion detektiert, so kann ein Fehlersignal erzeugt werden. Diese kann z. B. an ein übergeordnetes System übertragen werden und/oder in erfassbarer, z. B. in visuell oder akustisch wahrnehmbarer, Weise an einen Nutzer ausgegeben werden.

Vorzugsweise wird zusätzlich mit einem modulspezifischen Spannungssensor zusätzlich eine Modulspannung von mindestens einem Modul erfasst, vorzugsweise von jedem Modul. Dann kann der mindestens eine Sensorparameter des systemspezifischen Spannungssensors zusätzlich in Abhängigkeit der mindestens einen Modulspannung bestimmt werden.

Hierdurch ergibt sich in vorteilhafter Weise, dass in modular ausgestalteten elektrischen Systemen eine zuverlässige Bestimmung von Sensorparametern ermöglicht wird, insbesondere um diese zu Kalibrieren oder eine Fehlerkompensation durchzuführen, und/oder eine zuverlässige Fehlererkennung zu ermöglichen, insbesondere für komplexere und vielseitige Systemen, für die ein zunehmender Bedarf an genauen und zuverlässigen Messungen besteht, um ihre optimale Leistung und Sicherheit zu gewährleisten. Das Verfahren ist insbesondere anwendbar für modulare und somit insbesondere rekonfigurierbare Speicher-/Batteriesysteme, modulare rekonfigurierbare PV-Systeme als auch modulare Energieumwandlungssysteme.

Hierbei wird die Grundidee genutzt, dass bestimmte Systemkonfigurationen eingestellt werden, was einen einzigartigen Vorteil bei der Erkennung von Sensorfehlern und/oder der Korrektur von insbesondere Verzerrungen ermöglicht. Dies kann insbesondere erreicht werden, indem die unabhängige Überwachung von Modul- und System-Ausgangsmessungen sowie die vorhandenen Freiheitsgrade für Schaltvorgänge zur Rekonfiguration der Modulanordnung innerhalb des Systems genutzt werden. Wie nachfolgend noch näher erläutert, kann das Verfahren in verschiedenen Betriebsmodi des Systems durchgeführt werden:
- Trennen oder Leerlauf (Leerlaufzustand): Das System ist von jeglicher Last und/oder Ladegeräten getrennt, daher kann das System leicht rekonfiguriert werden, um den Betriebsmodus in den gewünschten Bereich zu bringen.
- Unter Last/Ladung (Lastzustand): Das System stellt aktiv Strom bereit oder nimmt ihn auf. Da die Ausgangsspannung, der Strom oder die Leistung des Systems gesteuert wird, kann das System nur so lange umkonfiguriert werden, wie die gleichen Ausgangspegel relativ konstant gehalten werden. Daher ist die Anzahl der verfügbaren redundanten Zustände eher begrenzt.

Das Verfahren kann, zusätzlich zur Bestimmung eines Sensorparameters des systemspezifischen Spannungssensors und/oder zu dessen Fehlerdiagnose, auch zum selben Zweck für die erwähnten modulspezifischen Spannungssensoren angewendet werden.

In einer weiteren Ausführungsform wird in einem Systemkonfigurationszustand mit einem modulspezifischen Spannungssensor zusätzlich eine Modulspannung von mindestens einem Modul erfasst, wobei der mindestens eine systemsensorspezifische Sensorparameter zusätzlich in Abhängigkeit der mindestens einen Modulspannung bestimmt wird. Es ist z. B. möglich, dass genau ein Modul aktiviert wird. Dann kann die erfasste zustandsspezifischen Systemspannung mit der erfassten Modulspannung verglichen werden. Beispielsweise kann dann als systemsensorspezifischer Parameter eine Verzerrung als Differenz zwischen den beiden Spannungen bestimmt werden, insbesondere wenn angenommen wird, dass der modulspezifische Spannungssensor eine höhere Messgenauigkeit, z. B. eine geringere Toleranz, aufweist. Insbesondere kann somit die Verzerrung für mindestens einen Arbeitspunkt, in dem als Ausgangsspannung die Modulspannung eines Moduls bereitgestellt wird, bestimmt werden.

Alternativ oder kumulativ kann eine Fehlfunktion des systemspezifischen Spannungssensors detektiert werden, wenn die die erfassten Spannungen mehr als ein vorbestimmtes Maß voneinander abweichen.

Hierdurch wird in vorteilhafter Weise die Zuverlässigkeit und Genauigkeit bei der Bestimmung von Sensorparametern und/oder die Zuverlässigkeit der Fehlererkennung weiter verbessert.

In einer bevorzugten Ausführungsform wird ein Sensorparameter des modulspezifischen Spannungssensors in Abhängigkeit der zustandsspezifischen Systemspannung und der Modulspannung bestimmt. Es ist z. B. möglich, dass genau ein Modul aktiviert wird. Dann kann die erfasste zustandsspezifischen Systemspannung mit der erfassten Modulspannung verglichen werden. Dann kann als modulsensorspezifischer Parameter eine Verzerrung als Differenz zwischen den beiden Spannungen bestimmt werden, insbesondere wenn der systemspezifische Spannungssensor eine höhere Messgenauigkeit aufweist. Alternativ oder kumulativ kann eine Fehlfunktion des systemspezifischen Spannungssensors detektiert werden, wenn die erfassten Spannungen mehr als ein vorbestimmtes Maß voneinander abweichen.

Hierdurch wird in vorteilhafter Weise die Zuverlässigkeit und Genauigkeit bei der Bestimmung von Sensorparametern und/oder die Zuverlässigkeit der Fehlererkennung weiter verbessert, da auch modulspezifische Spannungssensoren überwacht werden können.

In einer weiter bevorzugten Ausführungsform wird eine Mehrzahl von verschiedenen Systemkonfigurationszuständen eingestellt und die entsprechenden zustandsspezifischen Systemspannung erfasst, wobei der mindestens eine systemsensorspezifische Sensorparameter in Abhängigkeit der erfassten Systemspannungen bestimmt wird. Selbstverständlich können in diesen verschiedenen Systemkonfigurationszuständen auch die modulspezifischen Modulspannung der aktivierten Module erfasst werden und bei der Bestimmung des systemsensorspezifischen Sensorparameters berücksichtigt werden. Alternativ oder kumulativ können die erfassten Spannungen auch bei der Bestimmung der modulsensorspezifischen Sensorparameter berücksichtigt werden. Gleiches gilt für die Fehlerdetektion.

Bei einem modularen elektrischen System, in dem eine Modulanzahl von N Modulen in Reihe geschaltet werden können, kann eine Anzahl von N Systemkonfigurationszuständen eingestellt werden, in denen jeweils genau ein Modul aktiviert und die verbleibenden Module deaktiviert sind, wobei die Anzahl von Systemkonfigurationszuständen der Modulanzahl entspricht. In jedem dieser N Systemkonfigurationszustände wird ein anderes Modul aktiviert. Weisen die Module das gleiche Modulausgangsspannungslevel auf, so können hiermit verschiedene Systemkonfigurationszustände zur Bereitstellung eines ersten Systemausgangsspannungslevels eingestellt werden. In jedem Systemkonfigurationszustand kann dann eine Differenz zwischen der zustandsspezifischen Systemspannung und der jeweiligen Modulspannung bestimmt werden. Dann kann ein Mittelwert dieser Differenzen bestimmt werden. Dann kann als systemsensorspezifischer Parameter eine Verzerrung als dieser Mittelwert bestimmt werden. Es ist möglich, dass bei dieser Bestimmung solche Modulspannungen nicht berücksichtig werden, die mehr als ein vorbestimmtes Maß von der in dem entsprechenden Systemkonfigurationszustand erfassten zustandsspezifischen Systemspannung abweichen, z. B. mehr als 10% oder mehr als 5%. Dann ist selbstverständlich die Mittelwertbildung entsprechend anzupassen. Somit kann also für einen Arbeitspunkt, in dem mit dem System eine Systemausgangsspannung mit einem ersten Systemausgangsspannungslevel bereitgestellt wird, eine Verzerrung des systemspezifischen Spannungssensors bestimmt werden.

Je nach Anzahl der einstellbaren Systemausgangsspannungslevel kann diese Vorgehensweise für weitere oder sogar alle einstellbaren Systemausgangsspannungslevel wiederholt werden, um eine Verzerrung des systemspezifischen Spannungssensors auch für weitere Arbeitspunkte des Systems zu bestimmen. Beispielsweise können zur Bereitstellung eines zweiten Systemausgangsspannungslevels verschiedene Modulpaare aktiviert werden, wobei diese zwei in Reihe geschaltete Module umfassen.

Wird die Verzerrung für mehrere Arbeitspunkte bestimmt, kann auch eine Verzerrungskorrekturfunktion bestimmt werden, die die Bestimmung und somit auch die Korrektur von Verzerrungen insbesondere für unbekannte Arbeitspunkte ermöglicht. Diese Funktion kann z. B. mit einer linearen oder nichtlinearen Regression bestimmt werden.

Hierdurch wird in vorteilhafter Weise die Zuverlässigkeit und Genauigkeit bei der Bestimmung von Sensorparametern und/oder die Zuverlässigkeit der Fehlererkennung weiter verbessert.

In einer weiteren Ausführungsform wird als Systemkonfigurationszustand
a) ein erster Systemkonfigurationszustand eingestellt, in dem alle Module deaktiviert sind oder
b) ein zweiter Systemkonfigurationszustand eingestellt, in dem genau ein Modul des Systems aktiviert ist oder
c) ein dritter Systemkonfigurationszustand eingestellt, in dem genau eine Anzahl von n Modulen des Systems aktiviert sind, wobei die Anzahl n größer als Eins ist.

Mit diesen Systemkonfigurationszuständen können in vorteilhafter Weise verschiedene Systemausgangsspannungslevel bereitgestellt und somit eine Verzerrung für verschiedene Arbeitspunkte bestimmt werden.

Auch hierdurch wird in vorteilhafter Weise die Zuverlässigkeit und Genauigkeit bei der Bestimmung von Sensorparametern und/oder die Zuverlässigkeit der Fehlererkennung weiter verbessert.

In einer weiteren Ausführungsform wird eine zustandsspezifische Systemspannung und eine Modulspannung des jeweils aktivierten Moduls für mindestens einen zweiten Systemkonfigurationszustand bestimmt, wobei der mindestens eine Sensorparameter des systemspezifischen Spannungssensors in Abhängigkeit dieser zustandsspezifischen Systemspannung und der Modulspannung als aktualisierter Sensorparameter bestimmt wird. Hierbei wird angenommen, dass die zustandsspezifische Systemspannung, die zur Bestimmung des aktualisierten Sensorparameters verwendet wird, bereits mit einem nicht aktualisierten und gegebenenfalls inkorrekten Sensorparameter bestimmt wurde.

Beispielsweise kann das Modul aktiviert werden, dessen Spannungssensor die höchste Messgenauigkeit aufweist. Insbesondere in diesem Fall kann das modulare elektrische System derart ausgebildet sein, dass der Spannungssensor von genau einem oder mehreren Modul(en) eine höhere Messgenauigkeit aufweist als die Messgenauigkeit der Spannungssensoren der verbleibenden Module.

Selbstverständlich kann die zustandsspezifische Systemspannung und eine Modulspannung des jeweils aktivierten Moduls für mehrere Systemkonfigurationszustände und/oder kann die zustandsspezifische Systemspannung für den ersten Systemkonfigurationszustand bestimmt werden, wobei der mindestens eine Sensorparameter des systemspezifischen Spannungssensors in Abhängigkeit dieser zustandsspezifischen Systemspannungen und der jeweiligen Modulspannung als aktualisierter Sensorparameter und/oder der im ersten Systemkonfigurationszustand bestimmten Systemspannung bestimmt wird.

Dann kann für mehrere voneinander verschiedene zweite Systemkonfigurationszustände die Modulspannung des jeweils aktivierten Moduls sowie die zustandsspezifische Systemspannung bestimmt werden, wobei die zustandsspezifische Systemspannung mit dem aktualisierten Sensorparameter bestimmt wird, wobei der mindestens eine Sensorparameter des modulspezifischen Spannungssensors in Abhängigkeit der jeweiligen Modulspannung und der zustandsspezifischen Systemspannung bestimmt wird.

Mit anderen Worten wird also mit vergleichsweise wenig Aufwand zuerst der Sensorparameter des systemspezifischen Spannungssensors und dieser dann genutzt, um die Sensorparameter der modulspezifischen Spannungssensoren zu bestimmen.

Hierdurch wird in vorteilhafter Weise eine zeitlich schnelle und einfach implementierbare Verbesserung der Zuverlässigkeit und Genauigkeit bei der Bestimmung von Sensorparametern und/oder der Zuverlässigkeit der Fehlererkennung erreicht.

In einer weiteren Ausführungsform erfolgt das Bestimmen von mindestens einem Sensorparameter in Abhängigkeit mindestens einer Sensortoleranz. Insbesondere können die erfassten (System- oder Modul-)Ausgangsspannungen umso stärker bei der Bestimmung von Sensorparametern berücksichtigt werden, je niedriger ihrer Sensortoleranz bzw. je höher die jeweilige Messgüte ist. Auch hierdurch wird in vorteilhafter Weise die Zuverlässigkeit und Genauigkeit bei der Bestimmung von Sensorparametern und/oder die Zuverlässigkeit der Fehlererkennung weiter verbessert.

In einer weiteren Ausführungsform wird das Verfahren in einem Leerlaufzustand oder in einem Lastzustand des Systems durchgeführt. Diese Zustände wurden vorhergehend bereits erläutert. Im Lastzustand können jedoch nur die Systemkonfigurationszustände eingestellt werden, die eine lastabhängige Systemausgangsspannung bereitstellen bzw. in denen die bereitgestellte Systemausgangsspannung nicht mehr als ein vorbestimmtes Maß von dieser lastabhängigen Systemausgangsspannung abweicht. Während im Leerlaufzustand in vorteilhafter Weise ein Sensorparameter für eine Vielzahl von Arbeitspunkten bestimmt werden kann bzw. für eine Vielzahl von Arbeitspunkten eine Fehlfunktion des systemspezifischen Spannungssensors detektiert werden kann, erhöht die Durchführung des Verfahrens im Lastzustand in vorteilhafter Weise eine zeitliche Verfügbarkeit der Sensorüberwachung.

In einer weiteren Ausführungsform werden zur Einstellung verschiedener Systemkonfigurationszustände die Module zeitversetzt aktiviert. Beispielsweise kann zur Bereitstellung einer Systemausgangsspannung, die der Summe von zwei Modulausgangsspannungen von aktivierbaren Modulen, entspricht, zuerst ein erstes Modul und dann ein zweites Modul aktiviert werden. Hierdurch ergibt sich in vorteilhafter Weise, dass die Höhe von Spannungssprüngen bei der Einstellung der verschiedenen Systemkonfigurationszustände reduziert wird, was einerseits die Systembelastung reduziert und andererseits auch zu schnelleren Einschwingvorgängen führt. Dies wiederum kann eine Messgenauigkeit bei der Spannungserfassung erhöhen.

Die zeitversetzte Aktivierung eines Moduls kann insbesondere erfolgen, indem Trägersignale zur pulsweitenmodulierten Aktivierung verschiedener Module einen vorbestimmten Phasenversatz zueinander aufweisen. Bei einer solchen pulsweitenmodulierten Aktivierung wird das Trägersignal, das beispielsweise ein Dreieck- oder Sägezahnsignal sein kann, mit einem konstanten Referenzsignal verglichen. Steigt das Trägersignal über das Referenzsignal, so wird ein Modul aktiviert. Fällt das Trägersignal unter das Referenzsignal, so wird das Modul deaktiviert. Bei der pulsweitenmodulierten Aktivierung kann zur Einstellung verschiedener Systemausgangsspannungslevel das Referenzsignal auf einen spannungslevelabhängigen (konstanten) Wert eingestellt werden. Hierdurch ergibt sich in vorteilhafter Weise eine einfache Implementierung des beschriebenen Verfahrens.

Weiter kann eine Spannungsmessung einer vorbestimmte Zeitdauer nach einer Schaltsignalflanke zur Aktivierung oder Deaktivierung eines Moduls oder einer vorbestimmte Zeitdauer nach Erreichen einer vorbestimmten Amplitude des Trägersignals erfolgen.

Weiter vorgeschlagen wird ein System zur Sensorüberwachung in einem modularen elektrischen System, umfassend das modulare elektrische System, eine Einrichtung zum Einstellen mindestens eines Systemkonfigurationszustands, einen systemspezifischen Spannungssensor sowie mindestens eine Steuer- und Auswerteeinrichtung, wobei das System konfiguriert ist, ein Verfahren gemäß einer der in dieser Offenbarung beschriebenen Ausführungsformen durchzuführen. Selbstverständlich kann das System auch die beschriebenen modulspezifischen Spannungssensoren umfassen. Somit ergeben sich für das System die bereits erläuterten technischen Vorteile. Die Steuer- und Auswerteeinrichtung kann die Einrichtung zum Einstellen mindestens eines Systemkonfigurationszustands bilden.

Weiter beschrieben wird ein Fahrzeug mit einem solchen System, wobei das modulare elektrische System in diesem Fall insbesondere ein Speichersystem oder ein Wandlersystem sein kann.

Die Erfindung wird anhand von Ausführungsbeispielen erläutert. Die Figuren zeigen:
- Fig. 1: eine schematische Ansicht eines modularen elektrischen Systems,
- Fig. 2: eine schematische Ansicht eines modularen elektrischen Systems in einer weiteren Ausführungsform,
- Fig. 3: eine schematische Ansicht eines modularen elektrischen Systems in einer weiteren Ausführungsform,
- Fig. 4: ein schematisches Flussdiagramm eines erfindungsgemäßen Verfahrens,
- Fig. 5: ein schematisches Flussdiagramm eines erfindungsgemäßen Verfahrens in einer weiteren Ausführungsform und
- Fig. 6: Wahrscheinlichkeitsverteilungsfunktionen von einem systemspezifischen Spannungssensor und einer Gesamtheit von modulspezifischen Spannungssensoren.

Nachfolgend bezeichnen gleiche Bezugszeichen Elemente mit gleichen oder ähnlichen technischen Merkmalen.

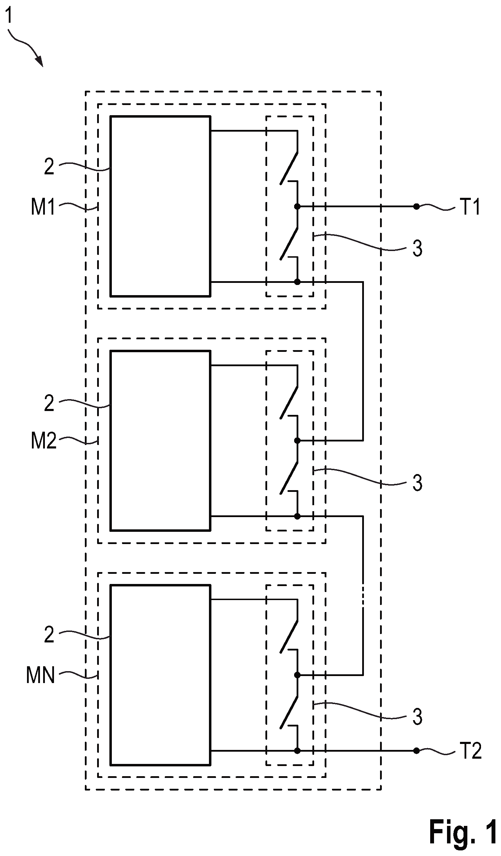

Fig. 1 zeigt eine schematische Ansicht eines modularen elektrischen Systems 1. Das System 1 umfasst eine Modulanzahl N von Modulen M1, M2, ..., MN. Jedes Modul M1, M2, ..., MN umfasst ein Energiespeicher- oder ein Energiequellensubmodul 2 sowie ein Schaltsubmodul 3 zur Aktivierung und Deaktivierung des jeweiligen Moduls M1, M2, ..., MN. In dem in Fig. 1 dargestellten Ausführungsbeispiel können die Module M1, M2, ..., MN in Reihe geschaltet werden. Ein aktiviertes Modul M1, M2, ..., MN ist Teil der Reihenschaltung, ein deaktiviertes Modul ist überbrückt. Durch Ansteuerungen der Schaltsubmodule 3 können verschiedene Systemkonfigurationszustände eingestellt werden, wobei in verschiedenen Systemkonfigurationszuständen die Anzahl und/oder die Ordnungsnummer(n) der aktivierten Module M1, M2, ..., MN variieren. Die Module M1, M2, ..., MN können austauschbare Module sein. Das dargestellte System 1 ermöglicht eine leichte Rekonfiguration, insbesondere um sich an veränderte Betriebsbedingungen, Anforderungen oder Umgebungen anzupassen. Weiter dargestellt sind die Ausgangsanschlüsse T1, T2 des Systems 1. An diesen kann eine zustandsspezifische Systemspannung erfasst werden.

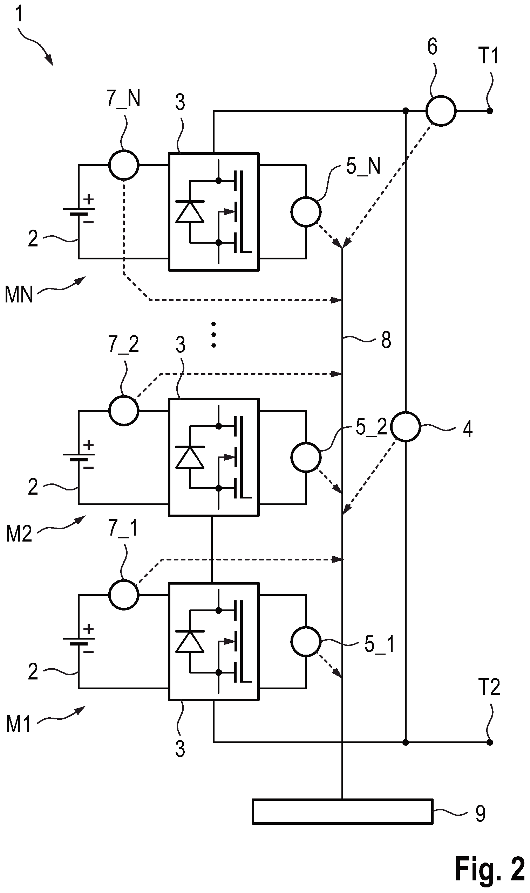

Fig. 2 zeigt eine schematische Ansicht eines modularen elektrischen Systems 1 in einer weiteren Ausführungsform. Das System 1 umfasst eine Modulanzahl N von Modulen M1, M2, ..., MN. Weiter umfasst das System 1 einen systemspezifischen Spannungssensor 4, der eine Systemspannung, die zwischen Ausgangsanschlüssen T1, T2 des Systems 1 abfällt, erfasst. Ebenfalls umfasst das System 1 für jedes Modul M1, M2, ... MN einen modulspezifischen Spannungssensor 5_1, 5_2, ..., 5_N, die jeweils eine Ausgangsspannung eines der Module M1, M2, ..., MN erfassen. Das System 1 kann optional noch einen systemspezifischen Stromsensor 6 zur Erfassung des über den ersten Ausgangsanschluss in das System 1 oder aus dem System 2 fließenden Stroms umfassen. Weiter optional kann das System 1 auch Stromsensoren 7_1, 7_2, ..., 7_N umfassen, die einen Modulstrom erfassen.

Die Sensoren 4, 5_1, 5_2, ..., 5_N, 6, 7_1, 7_2, ..., 7_N sind über eine Signal- oder Datenleitung 8 mit einer Steuer- und Auswerteeinrichtung 9 verbunden. Diese dient als Einrichtung zur Sensorüberwachung und kann einen Sensorparameter, insbesondere eine Verzerrung, eines Spannungssensors 4, 5_1, 5_2, ..., 5_N bestimmen und/oder eine Fehlfunktion eines Spannungssensors 4, 5_1, 5_2, ..., 5_N detektieren.

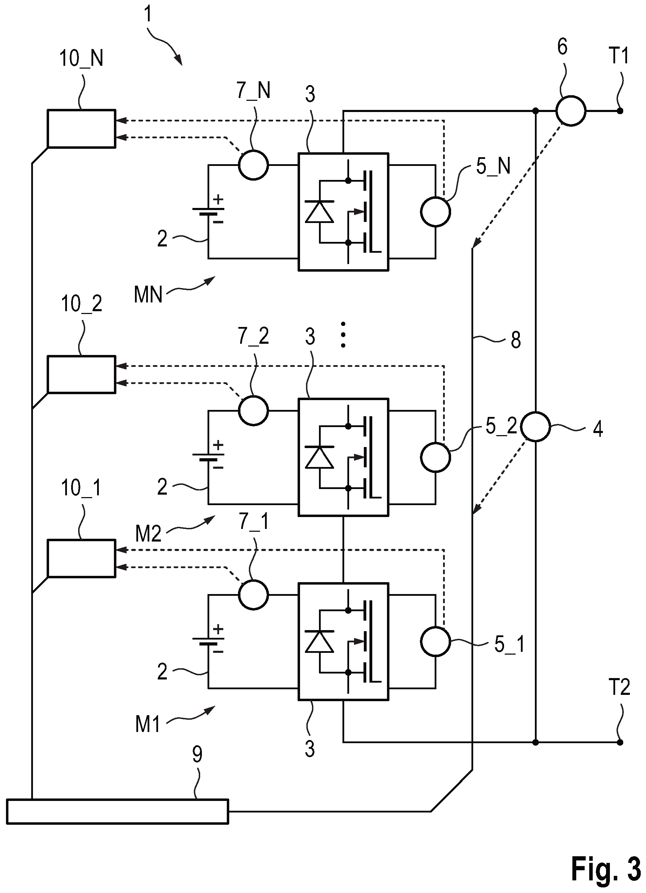

Fig. 3 zeigt eine schematische Ansicht eines modularen elektrischen Systems 1 in einer weiteren Ausführungsform. Das in Fig. 3 dargestellte System ist im Wesentlichen wie das in Fig. 2 dargestellte System 1 ausgebildet. Daher kann auf die entsprechenden Ausführungen verwiesen werden. Im Unterschied zu der in Fig. 2 dargestellten Ausführungsform werden Sensorausgangssignale der modulspezifischen Sensoren 5_1, 5_2, ..., 5_N, 7_1, 7_2, ..., 7_N über Signal- oder Datenleitungen an modulspezifische Auswerteeinrichtungen 10_1, 10_2, ..., 10_N und von diesen ebenfalls über eine Signal- oder Datenleitung an die Steuer- und Auswerteeinrichtung 9 übertragen.

Wird angenommen, dass bei den in Fig. 1, Fig. 2 und Fig. 3 dargestellten Systemen 1 die Modulausgangsspannungslevel jedes Moduls M1, M2,..., MN gleich sind, dann kann eine Spannungslevelanzahl N von verschiedenen Systemausgangsspannungsleveln eingestellt werden. Weiter kann ein Verfahren zur Sensorüberwachung des modularen elektrischen Systems 1 durchgeführt werden. Hierzu stellt die Steuer- und Auswerteeinrichtung 9 mehrere voneinander verschiedene Systemkonfigurationszustände ein. In jedem dieser Zustände werden mit dem systemspezifischen Spannungssensor 4 eine zustandsspezifische Systemspannung und mit den modulspezifischen Spannungssensoren die Modulspannungen der im eingestellten Systemkonfigurationszustand aktivierten Module erfasst. Dann werden mit der Steuer- und Auswerteeinrichtung 9 ein Sensorparameter des systemspezifischen Spannungssensors 4 sowie der modulspezifischen Spannungssensoren 5_1, 5_2,..., 5_N, insbesondere eine Verzerrung (Bias), bestimmt. Alternativ kann eine Fehlfunktion der Spannungssensoren 4, 5_1, 5_2,..., 5_N detektiert werden.

Zur Bestimmung einer Verzerrung des systemspezifischen Spannungssensors 4 können in einem Leerlaufzustand folgende Schritte durchgeführt werden:
i. In einem ersten Schritt werden zur Einstellung eines ersten
   Systemkonfigurationszustands alle Module M1, M2,..., MN überbrückt. Dann sind die Modulspannungen Null und die Systemausgangsspannung V_oO wird gemessen. Da alle Module umgangen werden, ist die Soll-Systemausgangsspannung Null. Die Verzerrung des systemspezifischen Spannungssensors 4 im Arbeitspunkt des Systems 1, in dem eine Nullspannung bereitgestellt wird, ist B_0 = V_oO.
ii. Dann werden verschiedenen Systemkonfigurationszustände zur Bereitstellung eines ersten Systemausgangsspannungslevels eingestellt, welches der Modulspannung genau eines aktivierten Moduls M1, M2, ..., MN entspricht. So werden in diesen Zuständen jeweils genau ein Modul M1, M2, ..., MN aktiviert, während die verbleibenden Module M1, M2, ... , MN deaktiviert, also überbrückt, werden. Dann werden die Systemausgangsspannung V_o1,i und die Modulspannung des aktivierten i-ten Moduls V_i gemessen. Modulspannungen V_i, die mehr als ein vorbestimmtes Maß von der entsprechenden Systemausgangsspannung Vo1,i abweichen, werden nicht berücksichtigt. Dann wird die Differenz der berücksichtigten Spannungen bestimmt und ein Mittelwert der derart bestimmten Differenzen bestimmt. Dieser Mittelwert ist die Verzerrung B_1,avg des systemspezifischen Spannungssensors 4 im Arbeitspunkt des Systems 1, in dem das erste Systemausgangsspannungslevel bereitgestellt wird. ${B}_{1 , avg} = \frac{{\sum }_{i} \left({V}_{o 1 , i}-{V}_{i}\right)}{\left(N-{n}_{outliers}\right)}$ Formel 1, wobei n_outlier die Anzahl von nichtberücksichtigten Modulspannungen bezeichnet.
iii. Dieser Vorgang wird in ähnlicher Weise wiederholt, indem nun verschiedene Systemkonfigurationszustände zur Bereitstellung eines zweiten Systemausgangsspannungslevels eingestellt werden, welches der Summe von Modulspannungen von zwei aktivierten Modulen M1, M2, ..., MN entspricht. Somit werden also in den jeweiligen Systemkonfigurationszuständen ein erstes Modul i und ein zweites Modul j aktiviert. Erneut wird die Differenz der jeweiligen Systemausgangsspannung V_o2,ij und der jeweiligen Modulspannungen V_i, V_j und deren Mittelwert bestimmt. Dieser Mittelwert ist die Verzerrung B_2,avg des systemspezifischen Spannungssensors 4 im Arbeitspunkt des Systems 1, in dem das zweite Systemausgangsspannungslevel bereitgestellt wird. ${B}_{2 , avg} = \frac{2 {\sum }_{j} {\sum }_{i} \left({V}_{o 2 , ji}-{V}_{i}-{V}_{j}\right)}{\left(N-{n}_{outliers}\right) \left(N-1-{n}_{outliers}\right)} mit i \neq j = 1 , … , N und i < j$ Formel 2, wobei n_outlier die Anzahl von nichtberücksichtigten Modulspannungen bezeichnet.
iv. Dies kann dann in analoger Weise für alle einstellbaren
   Systemausgangsspannungslevel wiederholt werden, um Verzerrungen für weitere Arbeitspunkte zu bestimmen.

Dann kann eine kontinuierliche Verzerrungskorrekturfunktion für eine kontinuierliche Spannungsmessung durch lineare und nichtlineare multivariable Regression abgeleitet werden, z. B. durch Anpassung einer Polynomfunktion P(x)=a_0 + a_1·x + a_2·x^2 + ... + a_q·x^q vom Grad q an die durchschnittlichen Verzerrungen in jedem Arbeitspunkt, wobei x die Anzahl der aktivierten Module M1, M2,..., MN oder die Systemausgangsspannung und P(x) die Verzerrungen sind. Die Koeffizienten a_0, a_1,..., a_q können durch Anwendung einer Regressionsmethode wie der Methode der kleinsten Quadrate bestimmt werden. Sobald die Polynomfunktion angepasst ist, kann sie verwendet werden, um die Messungen auf der Systemebene für jedes Spannungsniveau innerhalb des angegebenen Bereichs zu korrigieren, und zwar mit V_o_corrected=V_o-P(x).

Somit kann also die Systemausgangsspannung mit Hilfe der wie erläutert bestimmten Verzerrungen korrigiert werden.

Bei der Einstellung eines Systemkonfigurationszustands sollte zwischen dem Schaltvorgang und der Messung genügend Zeit vergehen, damit die Sensormessungen einen stabilen Zustand erreichen können, was von der Dynamik des Sensors 4, 5_1, 5_2, ..., 5_N und des Systems 1 abhängt, z. B. mindestens einige µs, vorzugsweise einige ms, noch besser einige Sekunden.

Um das Rauschen für jedes Systemausgangsspannungslevel zu reduzieren, sollten die höherfrequenten Komponenten der Messungen, vorzugsweise Oberschwingungen, die mehr als das Hundertfache der Schaltfrequenz betragen, vorzugsweise mehr als das Zwanzigfache und idealerweise mehr als das Fünffache, mit einer Filtereinrichtung herausgefiltert werden. Die entsprechende Filtereinrichtung kann Teil des Systems 1 sein.

Zur Bestimmung einer Verzerrung eines modulspezifischen Spannungssensors 5_1, 5_2, ..., 5_N im Leerlaufzustand kann in jedem Systemkonfigurationszustand i, in dem z.B. ein erstes Systemausgangsspannungslevel bereitgestellt wird, eines der Modul M1, M2, ..., MN, z.B. das erste Modul M1 aktiviert werden, während die anderen Module M2, ... , MN überbrückt werden. Der Unterschied zwischen den Messungen V_o1,i, V_k des systemspezifischen Spannungssensors 4 und des entsprechenden modulspezifischen Spannungssensors 5_1 ergibt die Verzerrung des modulspezifischen Spannungssensors 5_1 gemäß B_5_1,1 = V_o1,i - V_k-B1,avg, wobei B1,avg die vorab bestimmte Verzerrung des systemspezifischen Spannungssensors 4 ist. Zwischen der Einstellung der einzelnen Systemkonfigurationszustände sollte genügend Zeit liegen, um sicherzustellen, dass die gemessenen Spannungen ausreichend rauschfrei sind.

In einem Lastzustand können die Module M1, M2, ..., MN k beliebig in das System 1 eingeschaltet oder aus dem System 1 herausgeschaltet werden, solange die Leistung des Systems 1 relativ unbeeinflusst bleibt. Vorzugsweise gibt es keinen Filter zwischen dem systemspezifischen Spannungssensor 4 und der von System 1 erzeugten Spannung, wobei auch die Ausgangsspannungen aller Module M1, M2, ..., MN relativ ähnliche Spannungswerte aufweisen und weniger als 10 %, idealerweise weniger als 5 %, voneinander abweichen.

Zur Bestimmung und Korrektur der Verzerrung des systemspezifischen Spannungssensors 4 können dann folgende Schritte ausgeführt werden.
i. In einem ersten Schritt werden dann alle Modulkombinationen ermittelt, die zu ähnlichen Systemausgangsspannungsleveln führen. Wenn beispielsweise die Anzahl der in Reihe geschalteten Module x und die Gesamtzahl der Module N beträgt, kann es so viele Permutationen geben wie *n=N!*/*((N - x)!),* wenn die Ausgangsspannungen der Module M1, M2, ..., MN annähernd gleich groß sind.
ii. Dann werden alle derart festgelegten Systemkonfigurationszustände i durchlaufen und jeweils die Summe der Modulspannungen V_M,i der aktivierten Module bestimmt und mit der zustandsspezifischen Systemspannung V_o,i verglichen, wobei die Verzerrung Bias_i des systemspezifischen Spannungssensors 4 für die im Systemkonfigurationszustand bereitgestellte Ausgangsspannung als die Differenz zwischen der zustandsspezifischen Systemspannung V_o,i und der Summe der Modulspannungen V_M,i bestimmt wird.
iii. Die derart ermittelten Verzerrungen werden dann gemittelt, um die Verzerrungen des systemspezifischen Spannungssensors 4 für dieses spezifische Systemausgangsspannungslevel zu bestimmen. Die gemittelte Verzerrung ergibt sich zu $Bias _ avg = \left(1/\left(n-n_outliers\right)\right) {\sum }_{-} \left(\left(i=1 to\left(n-n_outliers\right)\right)\right) Bias _ i$ Formel 3 wobei n_outliers die Anzahl der Fälle ist, in denen die berechneten Verzerrungen signifikant, z.B. mehr als 10% von einem Mittelwert aller Verzerrungen Bias_i abweicht.
iv. Der berechnete Verzerrungskorrekturpunkt wird dann - wie vorhergehend erläutert - zur Aktualisierung der Verzerrungskorrekturfunktion genutzt.

Bei hohen Lasten, bei denen die Spannungsabfälle auf den Leitungspfaden und den Schaltsubmodulen 3 höher als ein vorbestimmter Schwellwert sein können, können diese ebenfalls in die Berechnung der Verzerrungen einbezogen werden, wie z. B. in dem Dokument "Tashakor et al., "Low-Cost Parameter Estimation Approach for Modular Converters and Reconfigurable Battery Systems Using Dual Kalman Filter", in IEEE Transactions on Power Electronics, vol. 37, no. 6, pp. 6323-6334, June 2022, doi: 10.1109/TPEL.2021.3137879" beschrieben.

In Fällen, in denen die Module M1, M2, ..., MN deutlich unterschiedliche Modulspannungen aufweisen (z.B. in Anwendungen, die als asymmetrische modulare Multilevel-Konverter bekannt sind), ist das beschriebene Verfahren ebenfalls anwendbar. Die Anzahl der angeschlossenen Module M1, M2, ..., MN hängt jedoch von den einzelnen Modulspannungen ab und muss von Fall zu Fall berechnet werden.

Zur Bestimmung und Korrektur der Verzerrung der modulspezifischen Spannungssensoren 5_1, 5_2, ..., 5_N können im Lastzustand zwei Varianten ausgeführt werden:
In einer ersten Variante kann, wenn jeweils nur ein Modul M1, M2, ..., MN aktiviert wird, ein mit dem verzerrungskorrigierten systemspezifischen Spannungssensor 4 detektierter Spannungssprung als das Ergebnis des Einschaltens des Moduls M1, M2, ..., MN im System 1 interpretiert werden und die Amplitude des Spannungssprungs ist eine gute Annäherung an die Modulspannung des betreffenden Moduls.

Wenn das Modul j zu einem Zeitpunkt t seinen Zustand geändert hat und der sich daraus ergebende Spannungssprung bei den Messungen mit dem systemspezifischen Spannungssensor 4 sich zu $Δ V _ o = V _ o \left(t\right) - V _ o \left(t-1\right)$ Formel 4 ergibt, dann ist die Verzerrung der Messung am Modul j wie folgt $B _ Mj \left(t\right) = V _ j \left(t-1\right) - Δ V _ o$ Formel 5

Normalerweise enthalten die Messungen unter Last ein hohes Maß an Rauschen, weshalb ein praktischerer Ansatz darin besteht, ein schrittweises Aktualisierungsverfahren wie folgt zu verwenden: $B _ \left(Mj\right) \left(t\right) = f \left(B_\left(Mj\right)\left(t\right)\right) + g \left(V_j\left(t-1\right)-ΔV_o\right)$ Formel 6 wobei *f*(*x*)*+g*(*x*)*=x,* und *f*(*x*) und *g*(*x*) eine langsame Dynamik aufweisen, um die Auswirkungen des Messrauschens zu verringern. Zum Beispiel: *f*(*x*)*=*(1*-k*)*x* und *g*(*x*)*=kx,* wobei *k*«1. Im Prinzip stellt die Kombination von *f*(*x*) und *g*(*x*) ein Tiefpassfilter bereit. Unter der Annahme, dass S einen Vektor der Modulzustände und B_ML ein Vektor der Verzerrungen ist, kann dies allgemeiner wie folgt ausgedrückt werden: ${B}_{ML} \left(t\right) = \left(I-S\left(t\right)+S\left(t-1\right)\right) . {B}_{ML} \left(t\right) + \left(S\left(t\right)-S\left(t-1\right)\right) . \left(f\left({B}_{ML}\left(t\right)\right)+g\left({V}_{ML}\left(t-1\right)-Δ{V}_{o}\right)\right)$ Formel 7, wobei V_ML (t) der Vektor der modulspezifischen Spannungsmessungen zum Zeitpunkt t ist.

Unter Bezugnahme auf diese Nomenklatur können in einer zweiten Variante alle Elemente des Bias-Vektors gleichzeitig aktualisiert werden durch $B _ ML \left(t\right) = \left(I-S\left(t\right)\right) B_ML \left(t\right) + S \left(t\right) \left(f\left(B_ML\left(t\right)\right)+g\left(S{\left(t\right)}^{∧}T V_ML\left(t\right)-V_o\right)\right)$ Formel 8.

Die Funktionen *f*(*x*) und *g*(*x*) verhalten sich als Rauschminderungs- und Begrenzungsfunktionen und haben die folgenden Eigenschaften $f \left(x\right) + g \left(x\right) = x , g \left(x\right) = \left\{\begin{matrix}0 \left|x\right| ≫ 0 \\ h \left(x\right) else\end{matrix}, h\left(x\right)\leq x.\right.$ Formel 9

In einer weiteren Implementierung der Verzerrungskorrektur unter Last kann zur Vermeidung fester Schätzwerte von Verzerrungen aufgrund einer festen Reihenfolge von Permutationen bei der Verbindung von Modulen M1, M2, ..., MN die Phasenverschiebung der Trägersignale und/ oder die Verbindungsreihenfolge der Module M1, M2, ..., MN - wie nachfolgend noch erläutert - auch nach einer bestimmten Zeitdauer geändert werden.

Eine Detektion einer Fehlfunktion des systemspezifischen Spannungssensors 4 kann erfolgen, indem man die Schwankungen in den Messwerten beobachtet, wenn sich die Modulkonfigurationen bzw. die Systemkonfigurationszustände ändern oder wenn der vom systemspezifischen Spannungssensor 4 erfasste Messwert variiert, obwohl keine Änderung des Systemkonfigurationszustands vorgenommen wird und die von den modulspezifischen Spannungssensoren 5_1, 5_2, ..., 5_N erfassten Modulspannungen keine Änderungen aufweisen. So kann eine Fehlfunktion detektiert werden, indem die vom systemspezifischen Spannungssensor 4 erfassten Messwerte beobachtet werden, wenn ein Systemkonfigurationszustand geändert wird. Weist ein Verlauf der Messwerte unerwartete Schwankungen oder Unstimmigkeiten auf, so kann eine Fehlfunktion detektiert werden.

Eine Fehlfunktion eines modulspezifischen Spannungssensors 5_1, 5_2, ..., ,5_N kann detektiert werden, wenn ein Systemkonfigurationszustand geändert wird und der von dem entsprechenden Sensor 5_1, 5_2, ..., 5_N erfasste Messwertverlauf unerwartete Schwankungen oder Unstimmigkeiten aufweist. Auch kann eine Fehlfunktion eines modulspezifischen Spannungssensors 5_1, 5_2, ..., ,5_N detektiert werden, wenn dessen Messwerte variieren und keine Änderung des Systemkonfigurationszustands vorgenommen wird (sowie gegebenenfalls die von dem systemspezifischen Spannungssensor4 erfasste Spannungen keine Änderungen aufweist).

Zusätzlich können die folgenden Fälle berücksichtigt werden:
Wenn sich der Zustand eines Moduls M1, M2, ..., MN von aktiviert in deaktiviert oder umgekehrt ändert und der von dem systemspezifischen Spannungssensor 4 kurz, insbesondere in einem Zeitraum bis zu 10 ms, idealerweise bis zu 10 µs, vor und nach dem Umschalten beobachtete Spannungssprung nicht mit dem Spannungssprung übereinstimmt, der von dem entsprechenden modulspezifischen Spannungssensor erfasst wird, so kann eine Fehlfunktion detektiert werden, insbesondere unter der Voraussetzung, dass keine Fehlfunktion des systemspezifischen Spannungssensors 4 detektiert wurde.

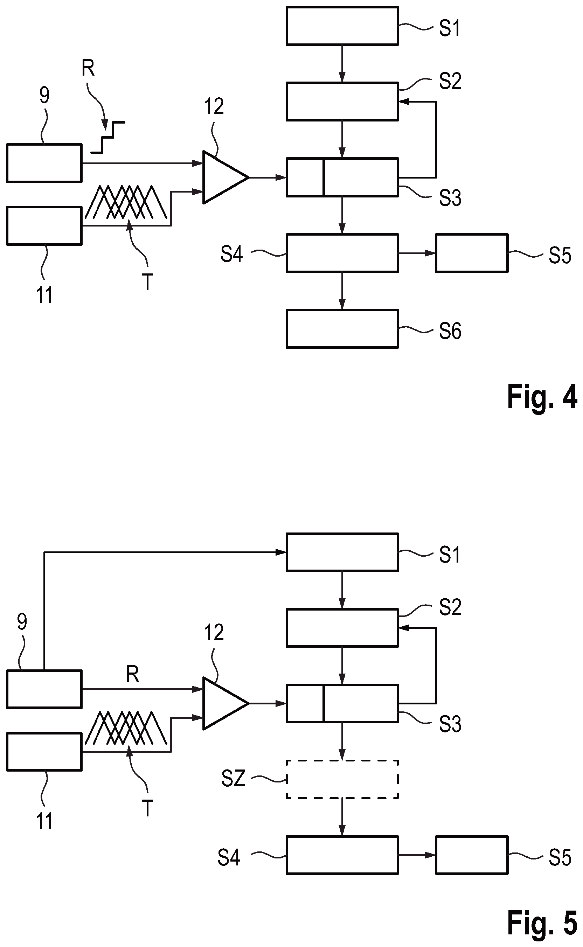

Fig. 4 zeigt ein schematisches Flussdiagramm eines erfindungsgemäßen Verfahrens zur Bestimmung einer Verzerrung des systemspezifischen Spannungssensors 4 in einem Leerlaufzustand. In dieser Ausführungsform wird das Konzept von phasenverschobenen Zählern (auch bekannt als phasenverschobene Trägermodulation) und sequentieller Abtastung umgesetzt, was den Vorteil hat, dass für ein Systemausgangsspannungslevel alle Möglichkeiten durchlaufen werden können, ohne dass die normale Modulationsstrategie geändert werden muss, und sogar verteilte Modulationsstrategien verwendet werden können.

Insbesondere wird mit der Steuer- und Auswerteeinrichtung 9 ein Spannungslevel eines Referenzsignals R auf einen systemausgangsspannungslevelspezifischen Wert eingestellt, insbesondere auf den Wert (j-0.5)/N, wobei j das bereitzustellende Systemausgangsspannungslevel bezeichnet. Mit einer Trägersignalerzeugungseinrichtung 11 werden zueinander phasenverschobene Trägersignale T erzeugt. Die Phasenlage der Trägersignale T ist vorzugsweise über eine Periodendauer eines Trägersignals T gleichverteilt. Hierbei wird für jedes Modul M1, M2, ..., MN ein Trägersignal T erzeugt. Das Referenz- und Trägersignal R, T werden durch einen Komparator 12 verglichen. Wird das modulspezifische Trägersignal T größer als das Referenzsignal R, so wird das entsprechende Modul M1, M2, ..., MN aktiviert. Wird es kleiner, wird das entsprechende Modul M1, M2, ..., MN deaktiviert. Die Steuer- und Auswerteeinrichtung 9, die Trägersignalerzeugungseinrichtung 11 und der Komparator 12 können Teil des in Fig. 1 dargestellten Systems 1, insbesondere Teil eines Modulationssubsystems, sein. Dies kann zur Einstellung von Modulzuständen in einem Verfahren zur Bestimmung einer Verzerrung des systemspezifischen Spannungssensors 4 wie folgt genutzt werden:
i. Nach einem Startschritt S1 werden basierend auf einem vorab festgelegten Systemausgangsspannungslevel j in einem zweiten Schritt S2 alle Permutationen von aktivierten und deaktivierten Modulzuständen, also alle möglichen Systemkonfigurationszustände, festgelegt, die das gewünschte Systemausgangsspannungslevel j bereitstellen. Dann wird ein erster Systemkonfigurationszustand dieser Menge eingestellt.
ii. In einem dritten Schritt S3 werden die Modulzustände in Abhängigkeit des Ausgangssignals des Komparators 12, das in Form von Schaltpulsen bereitgestellt wird, eingestellt. Hierdurch werden die verschiedenen Permutationen und somit Systemkonfigurationszustände eingestellt. In jedem Systemkonfigurationszustand werden die Systemausgangsspannung und die Modulspannung der aktivierten Module M1, M2, ..., MN gemessen. Nach dem dritten Schritt S3 kehrt das Verfahren zurück zum zweiten Schritt und es wird die nächste Permutation, also der nächste Systemkonfigurationszustand, eingestellt. Dies wird fortgesetzt, bis alle Systemkonfigurationszustände eingestellt wurden.
iii. In einem vierten Schritt S4 werden, wie vorhergehend erläutert, die Verzerrung des systemspezifischen Spannungssensors 4 und gegebenenfalls auch die Verzerrungen der modulspezifischen Spannungssensoren 5_1, 5_2, ..., 5_N bestimmt.
iv. In einem fünften Schritt S5 kann die Verzerrungskorrekturfunktion aktualisiert werden.
v. In einem sechsten Schritt S6 wird das Systemausgangsspannungslevel j auf einen geänderten Wert eingestellt, insbesondere auf das nächsthöhere Systemausgangsspannungslevel.

Das Verfahren kann von einem Überwachungssubsystem des in Fig. 1 dargestellten Systems 1 durchgeführt werden.

Die Abtastzeitpunkte der Spannungsmessung im dritten Schritt S3 werden vorzugsweise mit den steigenden oder fallenden Flanken der vom Komparator 12 erzeugten Schaltpulse synchronisiert. Z.B. kann bei Trägersignalen T mit Dreieckswellenform die Abtastung *T_C*/4*N* Sekunden nach der Erkennung einer positiven Flanke erfolgen, wobei T_C der Kehrwert der Schaltfrequenz eines Moduls M1, M2, ..., MN ist.

Alternativ kann der Abtastzeitpunkt in Abhängigkeit eines Werts eines Zählerstands, der den Wert eines Trägersignals T festlegt und hierzu von einem Minimalwert bis zu einem Maximalwert inkrementiert und dann wieder zum Minimalwert dekrementiert oder auf den Minimalwert zurückgesetzt wird, festgelegt werden. Beispielsweise kann die Abtastung mit einer vorbestimmten Zeitdauer nach Erreichen eines vorbestimmten Zählerstands, z. B. eines maximalen Zählerstands, erfolgen. Hierbei sollte der Kehrwert der Schaltfrequenz T_C mindestens so groß sein, dass die Messwerte und das modulare elektrische System 1 einen stabilen Zustand erreichen können, idealerweise sollte es 10-mal höher sein als ein von der Sensor-/Systemdynamik abhängiger Wert, vorzugsweise 10N-mal höher (wobei N die Anzahl der Module ist), und ganz besonders bevorzugt 100N-mal.

Fig. 5 zeigt ein schematisches Flussdiagramm eines erfindungsgemäßen Verfahrens zur Bestimmung einer Verzerrung des systemspezifischen Spannungssensors 4 in einem Lastzustand. Das Verfahren gleicht im Wesentlichen dem in Fig. 4 dargestellten Verfahren und es kann auf die entsprechenden Ausführungen verwiesen werden. Im Unterschied zu dem in Fig. 4 dargestellten Verfahren wird jedoch das Referenzsignal R von der Steuer- und Auswerteeinrichtung 9 gesteuert, insbesondere in Abhängigkeit des lastbedingten Systemausgangsspannungslevels. Insbesondere können nicht alle Systemausgangsspannungslevel durchlaufen werden. Vielmehr werden durch die Modulation alle möglichen Systemkonfigurationszustände zur Bereitstellung eines lastbedingten Systemausgangsspannungslevels j und des nächstniedrigeren Systemausgangsspannungslevels j-1 eingestellt.

In einem Zwischenschritt SZ kann ein ungefiltertes Spannungssignal abhängig von Filtereigenschaften von im modularen elektrischen System vorhandenen Filtern und dem gemessenen, gefilterten Spannungssignal bestimmt werden. Mit anderen Worten kann ein ungefiltertes Spannungssignal in Abhängigkeit des gefilterten und dann erfassten Spannungssignals bestimmt bzw. wiederhergestellt werden bzw. eine Abweichung zwischen dem ungefilterten und dem wiederhergestellten Spannungssignal minimiert werden. Auf diese Weise kann in vorteilhafter Weise z. B. ein Tiefpassverhalten eines Spannungssensors kompensiert werden. Dies ist insbesondere dann von Vorteil, wenn nicht die Möglichkeit besteht, die Zeitdauer der Einstellung eines Systemkonfigurationszustands derart lang einzustellen, dass ein Tiefpassverhalten des Sensors die Spannungsmessung nicht beeinträchtigt. Wenn die Funktion f(x) das ideale Ausgabesignal des Sensors (dynamisches Verhalten) als Reaktion auf ein Eingangssignal x beschreibt, der Spannungssensor aber zum Beispiel leichte Verzögerungen und ein Tiefpassverhalten aufweist, so kann das Eingangssignal mit dem Zusammenhang x = f^{-1}(f(x))) bestimmt werden.

Wenn alle Module M1, M2, ... , MN gleiche oder ähnliche Modulationsindizes haben, weist die Systemausgangsspannung eine pulsierende Wellenform, insbesondere in Form eines Rechtecksignals, mit dem N-fachen der Schaltfrequenz eines Moduls M1, M2, ... , MN auf, wobei sich als Maximalwert das j-te Systemausgangsspannungslevel und als Minimalwert das j-1-te Systemausgangsspannungslevel einstellen. Hierbei kann der Modulationsindex das Level des Referenzsignals bezeichnen, das zum Vergleich mit der Trägersignal verwendet wird. Jedes Modul kann einen ähnlichen oder einen individuellen Modulationsindex haben.

Wiederum können die Abtastzeitpunkte mit den steigenden oder fallenden Flanken der vom Komparator 12 erzeugten Schaltpulse synchronisiert werden, z. B. kann eine Abtastung *D*· *T_C*/2*N* Sekunde nach einer steigenden Flanke zur Erfassung des j-ten Systemausgangsspannungslevels und (1-*D*)·*T*_*C*/2*N* Sekunden nach einer fallenden Flanke erfolgen. Hierbei bezeichnet D ein Tastverhältnis.

Alternativ kann der Abtastzeitpunkt, wie vorhergehend erläutert, in Abhängigkeit eines Werts eines Zählerstands, der den Wert eines Trägersignals T festlegt, festgelegt werden, z.B. kann die Abtastung mit einer vorbestimmten Zeitdauer nach Erreichen eines vorbestimmten Zählerstands, z. B. eines maximalen Zählerstands, erfolgen. Auch kann eine Abtastung zur Erfassung des j-ten Systemausgangsspannungslevels unmittelbar beim Erreichen des Maximalwerts und ein Abtastzeitpunkt zur Erfassung des j-1-ten Systemausgangsspannungslevels unmittelbar beim Erreichen des Minimalwerts erfolgen. Die Abhängigkeit vom Zählerwert kann abhängig von der Form des Trägersignals eingestellt werden.

Werden auch die Verzerrungen der modulspezifischen Spannungssensoren 5_1, 5_2, ..., 5_N bestimmt und korrigiert, so sollte dies vorzugsweise basierend auf Messwerten erfolgen, die mit einem aktualisierten Sensorparameter des systemspezifischen Spannungssensor 4 bestimmt wurden.

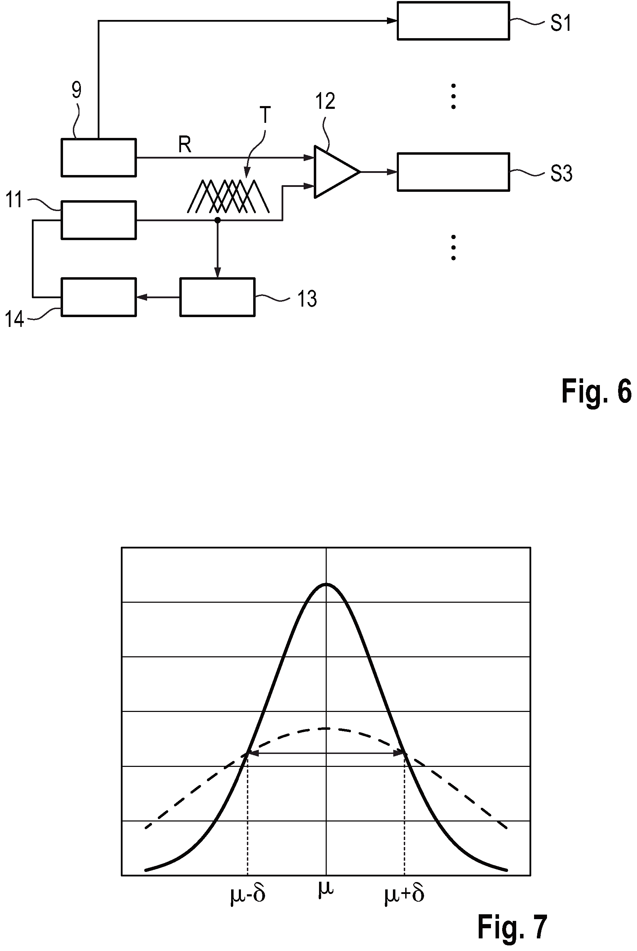

Fig. 6 zeigt ein schematisches Flussdiagramm eines erfindungsgemäßen Verfahrens in einer weiteren Ausführungsform zur Bestimmung einer Verzerrung des systemspezifischen Spannungssensors 4 in einem Lastzustand. Das Verfahren gleicht im Wesentlichen dem in Fig. 5 dargestellten Verfahren und es kann auf die entsprechenden Ausführungen verwiesen werden.

Während bei der in Fig. 5 dargestellten Ausführungsform die Systemkonfigurationszustände in einer festen Reihenfolge eingestellt werden, wird bei der in Fig. 6 dargestellten Ausführungsform der Phasenversatz zwischen den Trägersignalen T und/oder die Verbindungsreihenfolge der in dem aktuellen Systemkonfigurationszustand aktivierten Module M1, M2, ... , MN geändert, insbesondere nach einer vorbestimmten Zeitdauer, z.B. nach einem Vielfachen der Periodendauer eines Trägersignals oder eines Vielfachen einer Fundamentalfrequenz der Systemausgangsspannung.

Zu diesem Zwecke umfasst das System 1 einen Zähler 13 zur Bestimmung der vorbestimmten Zeitdauer und eine Einrichtung 14 zur Einstellung der Verbindungsreihenfolge und/oder des Phasenversatzes.

Wenn zum Beispiel die Verbindungsreihenfolge der Modulverbindung durch den Vektor P bestimmt wird, wobei das erste Element die Ordnungszahl des Moduls M1, M2, ..., MN ist, das als erstes verbunden wird, das zweite Element die Ordnungszahl des Moduls M1, M2, ..., MN ist, das Modul, das als zweites verbunden wird etc., so kann eine mögliche Variation der Reihenfolge [1, 2, 3]⇒[2, 3, 1]⇒[3, 1, 2] sein. In ähnlicher Weise können auch die Phasenverschiebungen der Trägersignale variieren [*ϕ*_1,*ϕ*_2,*ϕ*_3 ]⇒[*ϕ*_2,*ϕ*_3,*ϕ*_1]⇒[*ϕ*_3,*ϕ*_1,*ϕ*_2]. Dies kann durch die Trägersignalerzeugungseinrichtung 11 entsprechend berücksichtigt werden.

Fig. 7 zeigt Wahrscheinlichkeitsverteilungsfunktionen von einem systemspezifischen Spannungssensor 4 und einer Gesamtheit von modulspezifischen Spannungssensoren 5_1, 5_2, ... 5_N (siehe Fig. 2). Eine gestrichelte Linie entspricht hierbei der Wahrscheinlichkeitsverteilungsfunktion des systemspezifischen Spannungssensors 4. Sie gibt eine statische Verteilung von Messwerten bei wiederholter Messung genau eines Spannungswerts und somit ein Maß für die Messgüte an. Die Wahrscheinlichkeitsverteilungsfunktion der Gesamtheit von modulspezifischen Spannungssensoren 5_1, 5_2, ... 5_N wird abhängig von den Wahrscheinlichkeitsverteilungsfunktionen der einzelnen modulspezifischen Spannungssensoren 5_1, 5_2, ..., 5N bestimmt, die jeweils eine statische Verteilung von Messwerten bei wiederholter Messung genau eines Spannungswerts durch den entsprechenden Spannungssensors angeben.

Bei den bisherigen Ausführungen wurde davon ausgegangen, dass die modulspezifischen Spannungssensoren 5_1, 5_2, ..., 5_1 relativ einheitlich sind und ähnliche Toleranzen aufweisen (ähnliche Messgenauigkeit). Ist dies nicht der Fall, so kann eine Korrektur der Sensorverzerrungen auf der Grundlage von Ergebnissen heterogener Sensoren, d. h. mit unterschiedlichen Toleranzen, durchgeführt werden.

Um Sensortoleranzen bei der Verzerrungsbestimmung zu berücksichtigen, kann z. B. der Kehrwert der entsprechenden Toleranzen in die Verzerrungsbestimmung einbezogen werden. Dieser Ansatz stellt in vorteilhafter Weise sicher, dass Messungen mit geringeren Toleranzen , also höherer Messgenauigkeit, einen stärkeren Einfluss auf die Verzerrungsbestimmung haben.

So kann z. B. die Bestimmung der Verzerrungen unter Berücksichtigung der Sensortoleranzen erfolgen, indem der Kehrwert der quadrierten Standardabweichung in der Gleichung zur Bestimmung der Verzerrung verwendet wird. Für Gauß-verteilte Sensortoleranzen wie z. B. in Fig. 7 dargestellt, kann die Berechnung der Verzerrung wie folgt erfolgen: $Bias _ i = k _ i \left(V_SLi-Σ_\left(j=1 to n\right)V_MLij\right)$ Formel 10 wobei
- V_SLi die gemessene Systemausgangsspannung beim Einstellschritt n und dem eingestellten i-ten Systemkonfigurationszustand bezeichnet,
- V_MLij die Modulspannung für Modul j im n-ten Schritt und dem eingestellten i-ten Systemkonfigurationszustand bezeichnet, wobei n die Anzahl verschiedener Systemausgangsspannungslevel bezeichnet,
- k_i einen Konfidenzfaktor bezeichnet der als Quotient von einer Fläche unter der Wahrscheinlichkeitsverteilungsfunktion der Gesamtheit der aktivierten modulspezifischen Spannungssensoren 5_1, 5_2, ... 5_N und einer Fläche unter der Wahrscheinlichkeitsverteilungsfunktion des systemspezifischen Spannungssensors 4 im Bereich zwischen den Schnittpunkten der Wahrscheinlichkeitsverteilungsfunktionen bezeichnet.

Nachdem die Verzerrung für alle Permutationen/Systemkonfigurationszustände in jedem Schritt n berechnet wurden, wird der durchschnittliche Bias pro Schritt n wie folgt bestimmt $Bias _ \left(avg, n\right) = \left(Σ_i Bias_i\right) / \left(Σ_i k_i\right)$ Formel 11

Durch die Verwendung dieser Verzerrungsgleichung können Auswirkungen von Sensortoleranzen effektiv in den Vorspannungskorrekturprozess einbezogen, was zu einer genaueren und zuverlässigeren Bestimmung der Verzerrung führt.

### Bezugszeichenliste

- 1: System zur Sensorüberwachung
- 2: Energiequellensubmodul
- 3: Schaltsubmodul
- 4: Spannungssensor
- 5_1, 5_2, ..., 5_N: Spannungssensoren
- 6: Sensor
- 7_1, 7_2, ..., 7_N: Stromsensoren
- 8: Signal- oder Datenleitung
- 9: Steuer- und Auswerteeinrichtung
- 10_1, 10_2, 10_N: Auswerteeinrichtungen
- 11: Trägersignalerzeugungseinrichtung
- 12: Komparator
- 13: Zähler
- 14: Einrichtung zur Einstellung der Verbindungsreihenfolge
- M1, M2, ..., MN: Module
- N: Modulanzahl
- R: Referenzsignal
- S1-S6: Schritte
- T: Trägersignal
- T1, T2: Ausgangsanschlüsse

## Patentansprüche

1. Verfahren zur Sensorüberwachung in einem modularen elektrischen System (1), welches mehrere Module (M1, M2, ..., MN) mit jeweils einem Quellensubmodul (2) und einem Schaltsubmodul (3) zur Aktivierung oder Deaktivierung des Moduls (M1, M2, ..., MN) umfasst, umfassend die Schritte:
a) Einstellen mindestens eines Systemkonfigurationszustands,
b) Erfassen einer zustandsspezifischen Systemspannung (V_o) mit einem systemspezifischen Spannungssensor (4) für den mindestens einen Systemkonfigurationszustand,
c) Bestimmen von mindestens einem Sensorparameter des systemspezifischen Spannungssensors (4) und/oder Detektion einer Fehlfunktion des systemspezifischen Spannungssensors (4) in Abhängigkeit der zustandsspezifischen Systemspannung (V_o).

2. Verfahren nach Anspruch 1, **dadurch gekennzeichnet, dass** mit einem modulspezifischen Spannungssensor (5_1, 5_2, ..., 5_N) zusätzlich eine Modulspannung (V_j) von mindestens einem Modul (M1, M2, ... MN) erfasst wird, wobei der mindestens eine Sensorparameter zusätzlich in Abhängigkeit der mindestens einen Modulspannung (V_j) bestimmt wird.

3. Verfahren nach Anspruch 2, **dadurch gekennzeichnet, dass** ein Sensorparameter des modulspezifischen Spannungssensors (5_1, 5_2, ..., 5_N) in Abhängigkeit der zustandsspezifischen Systemspannung (V_o) und der Modulspannung (V_j) bestimmt wird.

4. Verfahren nach einem der vorangegangenen Ansprüche, **dadurch gekennzeichnet, dass** eine Mehrzahl von Systemkonfigurationszuständen eingestellt und die entsprechenden zustandsspezifischen Systemspannungen (V_o) erfasst werden, wobei der mindestens eine Sensorparameter in Abhängigkeit der erfassten Systemspannungen (V_o) bestimmt wird.

5. Verfahren nach einem der vorangegangenen Ansprüche, **dadurch gekennzeichnet, dass** als Systemkonfigurationszustand
a) ein erster Systemkonfigurationszustand eingestellt wird, in dem alle Module (M1, M2, ... MN) des Systems (1) deaktiviert sind oder
b) ein zweiter Systemkonfigurationszustand eingestellt wird, in dem genau ein Modul (M1, M2, ... MN) des Systems (1) aktiviert ist oder
c) ein dritter Systemkonfigurationszustand eingestellt wird, in dem genau eine Anzahl von n Modulen (M1, M2, ... MN) des Systems (1) aktiviert sind, wobei die Anzahl n größer als Eins ist.

6. Verfahren nach Anspruch 5, **dadurch gekennzeichnet, dass** eine zustandsspezifische Systemspannung (V_o) und eine Modulspannung (V_j) des jeweils aktivierten Moduls (M1, M2, ... MN) für mindestens einen zweiten Systemkonfigurationszustand bestimmt wird, wobei der mindestens eine Sensorparameter des systemspezifischen Spannungssensors (4) in Abhängigkeit dieser zustandsspezifischen Systemspannung (V_o) und der Modulspannung (V_j) als aktualisierter Sensorparameter bestimmt wird, wobei dann für mehrere voneinander verschiedene zweite Systemkonfigurationszustände die Modulspannung (V_j) des jeweils aktivierten Moduls (M1, M2, ... MN) sowie die zustandsspezifische Systemspannung (V_o) bestimmt wird, wobei die zustandsspezifische Systemspannung (V_o) mit dem aktualisierten Sensorparameter bestimmt wird, wobei der mindestens eine Sensorparameter des modulspezifischen Spannungssensors (4) in Abhängigkeit der jeweiligen Modulspannung (V_j) und der zustandsspezifischen Systemspannung (V_o) bestimmt wird.

7. Verfahren nach einem der vorangegangenen Ansprüche, **dadurch gekennzeichnet, dass** das Bestimmen von mindestens einem Sensorparameter in Abhängigkeit mindestens einer Sensortoleranz erfolgt.

8. Verfahren nach einem der vorangegangenen Ansprüche, **dadurch gekennzeichnet, dass** das Verfahren in einem Leerlaufzustand oder in einem Lastzustand des Systems (1) durchgeführt wird.

9. Verfahren nach einem der vorangegangenen Ansprüche, **dadurch gekennzeichnet, dass** zur Einstellung verschiedener Systemkonfigurationszustände die Module (M1, M2, ... MN) zeitversetzt aktiviert werden.

10. System zur Sensorüberwachung in einem modularen elektrischen System (1), umfassend das modulare elektrische System (1), eine Einrichtung zum Einstellen mindestens eines Systemkonfigurationszustands, einen systemspezifischen Spannungssensor (4) sowie mindestens eine Steuer- und Auswerteeinrichtung (9), wobei das System (1) konfiguriert ist, ein Verfahren gemäß einem der Ansprüche 1 bis 9 durchzuführen.
